(19) **Europäisches Patentamt European Patent Office Office européen des brevets**

(11) **EP 4 723 176 A1**

(12) **EUROPEAN PATENT APPLICATION**
published in accordance with Art. 153(4) EPC

(43) Date of publication:
08.04.2026 Bulletin 2026/15

(21) Application number: 23939662.5

(22) Date of filing: 31.05.2023

(51) International Patent Classification (IPC):
*H01L 31/10* (2006.01)  *G02F 2/02* (2006.01)

(52) Cooperative Patent Classification (CPC):
G02F 2/02; H10F 30/20

(86) International application number:
PCT/JP2023/020345

(87) International publication number:
WO 2024/247187 (05.12.2024 Gazette 2024/49)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
KH MA MD TN

(71) Applicant: Tohoku University
Sendai-shi, Miyagi 980-8577 (JP)

(72) Inventors:
• OTSUJI, Taiichi
  Sendai-shi, Miyagi 980-8577 (JP)
• SATOU, Akira
  Sendai-shi, Miyagi 980-8577 (JP)

(74) Representative: Kolster Oy Ab
Salmisaarenaukio 1
P.O. Box 204
00181 Helsinki (FI)

(54) **FREQUENCY DOWN-CONVERSION DEVICE AND COMMUNICATION DEVICE**

(57) The present invention improves conversion gain in frequency down-conversion. Provided is a frequency down-conversion device which receives input of an optical data signal and an optical subcarrier signal having different frequencies from each other in an infrared light frequency band and outputs a data signal having a radio wave band frequency or a baseband frequency. The device has a field-effect transistor structure in which a source electrode, a drain electrode, a first gate electrode having a plurality of parallelly arranged first fingers, and a second gate electrode having a plurality of parallelly arranged second fingers are arranged on a mesa. The plurality of first fingers and the plurality of second fingers are arranged in a nested state, the second gate electrode receives input of a local transmission signal having a frequency which is in a band between the sub-terahertz band and the terahertz band and is close to a difference frequency between the frequency of the optical data signal and the frequency of the optical subcarrier signal, and a data signal having a frequency corresponding to the absolute difference between a predetermined frequency and the difference frequency is output from the first gate electrode.

FIG.2

**Description**

Technical Field

The present invention relates to a frequency down-conversion device and a communication device.

Background Art

With increase in speed and bandwidth of wireless communication, a transmission speed of one wireless communication channel may reach a transmission speed of one optical fiber communication channel in the next-generation (beyond 5G, B5G) wireless communication technology. In the related art, since the transmission speeds of the optical fiber communication and the wireless communication are different from each other, different coding methods are adopted between the optical fiber communication and the wireless communication. Therefore, it is necessary to decode an optical data signal to acquire data and recode the data by a coding method of wireless communication to generate a wireless data signal. However, since the transmission speeds of the optical fiber communication and the wireless communication are about the same, it is possible to unify the coding methods, and it is possible to generate the wireless data signal from the optical data signal only by converting a carrier frequency. Accordingly, not only is signal processing greatly simplified, but power consumption of a system can also be significantly reduced.

In order to implement conversion of the above-described carrier frequency, a frequency down-conversion device for converting the optical data signal into a data signal in an intermediate frequency band is required. In particular, since a carrier frequency of the next-generation wireless communication signal is in a band from sub-terahertz to terahertz, and the intermediate frequency band is a radio wave band, a frequency down-conversion device capable of performing broadband conversion processing is required. As a device capable of implementing a function of such a frequency down-conversion device, recently, an asymmetric dual-grating gate (A-DGG) field effect transistor (FET) (see PTLs 1 and 2) and a photonics-electronics convergence transistor in which a single high electron mobility transistor (HEMT) and a photodiode (PD) are monolithically integrated (see NPLs 1 and 2) have been proposed.

Citation List

Patent Literature

PTL 1: JP5747420B
PTL 2: US7,915,641B

Non Patent Literature

NPL 1: A.Satou et al., "Unitraveling-Carrier-Photodiode-Integrated High-Electron-Mobility Transistor for Photonic Double-Mixing", Journal of Lightwave Technology, Vol.39, No.10, pp.3341-3349 (2021)
NPL 2: A.Satou et al., "UTC-PD-integrated HEMT for optical-to-terahertz carrier frequency down-conversion", Proceedings of SPIE, Vol.11390 (2020)
NPL 3: A.Satou, T.Otsuji, "Recent progress in the development of grating-gate InGaAs-channel HEMTs for fast and sensitive THz detection", Proceedings of SPIE, Vol.12230 (2022)

Summary of Invention

Technical Problem

However, in the devices of PTLs 1 and 2 and NPLs 1 and 2, a conversion gain required for practical use is not obtained, and a further improvement of the conversion gain is required.

The present inventor has recently proposed a terahertz wave detector including a rectification detection mechanism having extremely high detection sensitivity (see NPL 3). In this terahertz wave detector, an improvement of the detection sensitivity is implemented by adopting a gate readout type FET as a device that converts an optical wave input of a specific frequency into a photovoltage signal. Taking advantage of this knowledge, the present inventor has made a theoretical consideration for a frequency down-conversion device that implements frequency conversion by extracting a component of a difference frequency of a plurality of input signals having different frequencies, and has invented a mechanism of increasing a conversion gain in the frequency down-conversion device by one order of magnitude or more. An object of the present invention is to provide a frequency down-conversion device having a high conversion gain and a communication device including the same.

Solution to Problem

According to a first aspect of the present invention, there is provided a frequency down-conversion device for receiving an optical data signal and an optical subcarrier signal having different frequencies in an infrared optical frequency band and for outputting a data signal having a frequency in a radio wave band or a baseband. The device has a structure of a field effect transistor in which a source electrode, a drain electrode, a first gate electrode including a plurality of first fingers arranged in parallel at regular intervals, and a second gate electrode including a plurality of second fingers arranged in parallel at regular intervals are arranged on a mesa. The plurality of first fingers and the plurality of second fingers are arranged in a nested manner. A local oscillation signal having a predetermined frequency, which is close to a difference frequency between the frequency of the optical data signal and the frequency of the optical subcarrier signal and is in a band from sub-terahertz to terahertz, is input to the second gate electrode. The device is configured to output, from the first gate electrode, the data signal having a frequency corresponding to an absolute difference between the predetermined frequency and the difference frequency. According to such a configuration, a high conversion gain is implemented.

According to a second aspect of the present invention, there is provided a frequency down-conversion device for receiving an optical data signal and an optical subcarrier signal having different frequencies in an infrared optical frequency band and for outputting a data signal having a frequency in a radio wave band or a baseband. The device has a structure of a field effect transistor in which a source electrode, a drain electrode, and a gate electrode including a plurality of fingers arranged in parallel at regular intervals are arranged on a mesa. A local oscillation signal having a predetermined frequency, which is close to a difference frequency between the frequency of the optical data signal and the frequency of the optical subcarrier signal and is in a band from sub-terahertz to terahertz, is input to the drain electrode. The device is configured to output, from the gate electrode, the data signal having a frequency corresponding to an absolute difference between the predetermined frequency and the difference frequency. Optionally, the device may further include a plurality of floating patch electrodes arranged on the mesa and each arranged at a certain distance from a corresponding one of the fingers. According to such a configuration, a high conversion gain is implemented.

According to a third aspect of the present invention, there is provided a communication device including: an optical processing unit configured to input the optical data signal and the optical subcarrier signal transmitted via an optical fiber to the frequency down-conversion device according to the first aspect or the second aspect; the frequency down-conversion device; and a wireless processing unit configured to convert the data signal output from the frequency down-conversion device into a wireless signal and transmit the wireless signal via an antenna. According to such a configuration, a high conversion gain is implemented in the frequency down-conversion device, and it is possible to implement a small communication device with low power consumption.

Effect of Invention

According to one aspect of the present invention, it is possible to implement a frequency down-conversion device having a high conversion gain and a communication device including the same.

Brief Description of Drawings

FIG. 1 is a schematic diagram illustrating a functional configuration of a frequency down-conversion device;
FIG. 2 is a schematic diagram illustrating an electrode structure of the frequency down-conversion device;
FIG. 3 is a schematic diagram illustrating a layer structure and an electrode arrangement of the frequency down-conversion device;
FIG. 4 is a graph illustrating gate bias voltage dependence of a peak output photovoltage;
FIG. 5 is a diagram comparing output photovoltage waveforms for different bias voltage regions;
FIG. 6 is a diagram comparing output photovoltage waveforms for different compound semiconductor heteroepitaxial layer structures;
FIG. 7 is a schematic diagram illustrating a configuration of a frequency down-conversion device according to a variation; and
FIG. 8 is a schematic diagram illustrating a configuration example of a communication device in which the frequency down-conversion device is integrated.

Description of Embodiments

Hereinafter, an embodiment of the present invention will be described with reference to the accompanying drawings. In the present description and drawings, elements having substantially the same functions are denoted by the same reference numerals, and a redundant description thereof may be omitted.

As described above, in a next-generation (B5G) wireless communication network, a transmission speed of one wireless communication channel may reach a transmission speed of one optical fiber communication channel. Therefore, the same coding method can be adopted between the optical fiber communication and the wireless communication, and it is not necessary to decode an optical data signal and then recode the data for the wireless communication. In other words, a wireless data signal is obtained only by down-converting a carrier frequency of the optical data signal. Accordingly, it is possible to greatly simplify signal processing and greatly reduce power consumption.

In the related art, it is difficult to implement a frequency down-conversion device that obtains an intermediate frequency band or baseband signal (hereinafter, IF/BB signal) from a terahertz band optical data signal using a single element. However, recently, as a device capable of performing broadband conversion processing, an asymmetric dual-grating gate graphene FET (see PTLs 1 and 2) and a photonics-electronics convergence transistor in which a single high electron mobility transistor (HEMT) and a photodiode (PD) are monolithically integrated (see NPLs 1 and 2) have been proposed. Although these devices enable the broadband conversion processing using a single element, a practical level of conversion gain is not obtained, and a further improvement of the conversion gain is required.

The present inventor has recently proposed a terahertz wave detector including a rectification detection mechanism having extremely high detection sensitivity (see NPL 3). In this terahertz wave detector, an improvement of the detection sensitivity is implemented by adopting a gate readout type FET as a device that converts an optical wave input of a specific frequency into a photovoltage signal. That is, the present inventor has succeeded in improving the detection sensitivity by adopting a new method of reading the photovoltage signal from a gate electrode instead of a method, in the related art, of reading the photovoltage signal from a drain electrode. However, since an operation mechanism of the frequency down-conversion device is different from an operation mechanism of the terahertz wave detector, it is unclear whether the conversion gain can be improved by simply applying a gate readout method to the frequency down-conversion device.

Therefore, in order to evaluate an effect of improving the conversion gain by applying the gate readout method to the frequency down-conversion device, the present inventor modeled a nonlinear response of the frequency down-conversion device to a signal input, clarified a mechanism of the frequency conversion, and theoretically considered the effect of improving the conversion gain. As a result, it became clear that the conversion gain was significantly improved by applying the gate readout method. Hereinafter, a model of the frequency down-conversion device based on this consideration will be briefly described, and then an evaluation method of the conversion gain obtained by the gate readout method and an evaluation result indicating the improvement effect will be described.

(Configuration of Frequency Down-Conversion Device)

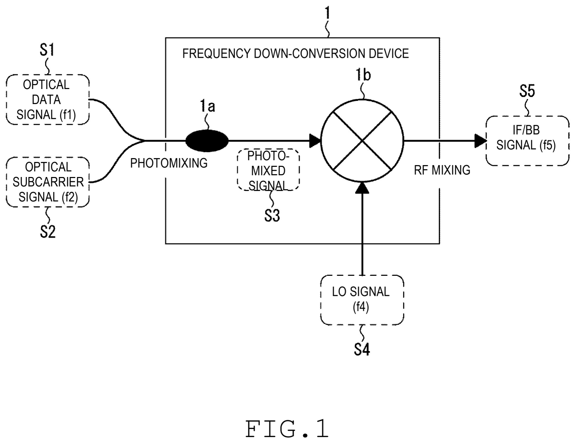

First, with reference to FIG. 1, the function of the frequency down-conversion device (frequency down-conversion device 1) according to the present embodiment will be described. As illustrated in FIG. 1, an optical data signal S1 having a carrier frequency f1 and an optical subcarrier signal S2 having a frequency f2 are input to the frequency down-conversion device 1. In addition, a local oscillation (LO) signal S4 having a frequency f4 is input from a local oscillator (not illustrated) to the frequency down-conversion device 1.

In the frequency down-conversion device 1, the optical data signal S1 and the optical subcarrier signal S2 are mixed, and a signal component (photomixed signal S3) having a difference frequency $\Delta f_{opt}$ ($\Delta f_{opt} = |f1 - f2|$) between the frequencies f1 and f2 is generated (photomixing 1a). Further, in the frequency down-conversion device 1, the photomixed signal S3 and an LO signal S4 are mixed, and a signal component having a difference frequency f5 (f5 = $|\Delta f_{opt} - f4|$) between the frequencies $\Delta f_{opt}$ and f4 is generated (RF mixing 1b). In the frequency down-conversion device 1 according to the present embodiment, this signal component is read from the gate electrode as an IF/BB signal S5.

The frequencies f1 and f2 are different frequencies in an infrared optical frequency band. The frequency f4 of the LO signal S4 is set to a frequency that is close to the difference frequency $\Delta f_{opt}$ between the frequencies f1 and f2 and is in a band from sub-terahertz to terahertz. Since a frequency corresponding to an absolute difference $|\Delta f_{opt} - f4|$ between the difference frequency $\Delta f_{opt}$ and the frequency f4 becomes the frequency f5 of the IF/BB signal S5, the frequency f4 is set such that the frequency f5 becomes a desired frequency (intermediate frequency or baseband frequency).

The frequency down-conversion device 1 has a structure of a field effect transistor, for example, an HEMT. An electrode structure of the frequency down-conversion device 1 may be an electrode structure described in any one of PTLs 1 and 2 and NPLs 1 to 3, that is, a diffraction grating gate structure including a source electrode, a drain electrode, and a plurality of gate electrodes, the gate electrodes being arranged in a diffraction grating pattern. A layer structure under the electrode may be, for example, a layer structure described in any of PTLs 1 and 2 and NPLs 1 to 3. Of course, an application range of the technology according to the present embodiment is not limited to the electrode structure and the layer structure described in PTLs 1 and 2 and NPLs 1 to 3, and any electrode structure and layer structure to which a theory described below can be applied can be included in the range.

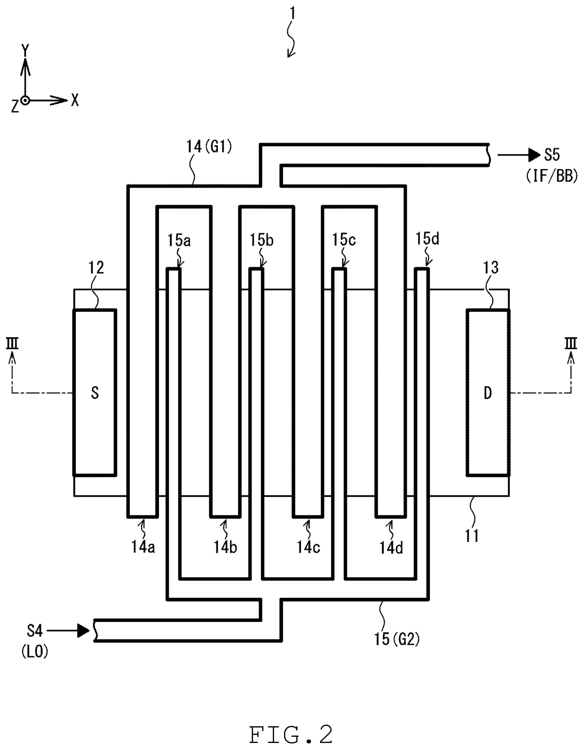

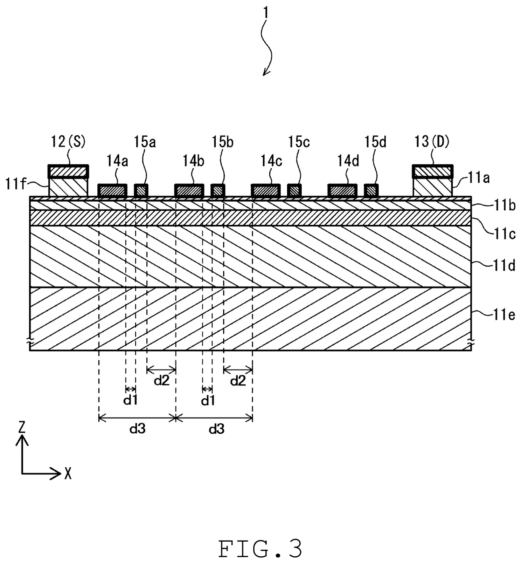

Hereinafter, an electrode structure and a layer structure illustrated in FIGS. 2 and 3 will be described as examples. FIG. 2 is a schematic diagram illustrating the electrode structure and the like of the frequency down-conversion device 1. FIG. 3 is a schematic diagram illustrating the layer structure and the like under the electrode. The electrode structure and the layer structure illustrated in FIGS. 2 and 3 are merely examples for explanation, and an application range of the present embodiment is not limited to these examples.

In the example of FIG. 2, the frequency down-conversion device 1 includes a source electrode 12, a drain electrode 13, a first gate electrode 14, and a second gate electrode 15. The electrodes are arranged on a mesa 11. In the following description, the first gate electrode 14 may be denoted as G1, and the second gate electrode 15 may be denoted as G2. The first gate electrode 14 includes a plurality of first fingers 14a, ..., 14d arranged in parallel at regular intervals. The second gate electrode 15 includes a plurality of second fingers 15a, ..., 15d arranged in parallel at regular intervals. The plurality of first fingers 14a, ..., 14d and the plurality of second fingers 15a, ..., 15d are arranged in a nested manner.

The source electrode 12 is grounded. The drain electrode 13 may be open, or a constant DC bias voltage may be applied to the drain electrode 13. The LO signal S4 having the frequency f4 close to the difference frequency $\Delta f_{opt}$ between the frequency f1 of the optical data signal S1 and the frequency f2 of the optical subcarrier signal S2 is input to the second gate electrode 15. In response to these inputs, in the frequency down-conversion device 1, the photomixed signal S3 is generated by the photomixing, and the IF/BB signal S5 having the frequency f5 is generated by the RF mixing. Then, the IF/BB signal S5 is output from the first gate electrode 14.

In the example of FIG. 3, the mesa 11 mainly includes cap layers 11a and 11f (Cap), a barrier layer 11b (Barrier), a channel and channel peripheral layer 11c (Carrier-supply/Spacer/Channel or Channel/Spacer/Carrier-supply), a buffer layer 11d (Buffer), and a substrate 11e (Substrate) in order from an electrode side. As a configuration of each layer, for example, the configuration described in any of PTLs 1 and 2 and NPLs 1 to 3 may be applied, or other configurations may be applied. Here, a channel layer (Channel), a carrier-supply layer (Carrier-supply), and a spacer layer (Spacer) are collectively referred to as the channel and channel peripheral layer 11c. The carrier-supply layer and the spacer layer are disposed above or below the channel layer. For reference, a layer configuration example of the HEMT is illustrated in Table 1 (Normal-type, corresponding to a configuration of the above-described channel and channel peripheral layer 11c (Carrier-supply/Spacer/Channel)) and Table 2 (Inversed-type, corresponding to a configuration of the above-described channel and channel peripheral layer 11c (Channel/Spacer/Carrier-supply)).

Table 1

| Layer | Material | Thickness (nm) |
|---|---|---|
| Cap | n-$In_{0.53}Ga_{0.47}As$ | 15 |
| | n-$In_{0.52}Al_{0.48}As$ | 15 |
| Etch-stop | n-InP | 6 |
| Barrier | i-$In_{0.52}Al_{0.48}As$ | 15 |
| Carrier-supply | n-$In_{0.52}Al_{0.48}As$ | 5 |
| Spacer | i-$In_{0.52}Al_{0.48}As$ | 3 |
| Channel | i-$In_{0.53}Ga_{0.47}As$ | 3 |
| | i-$In_{0.7}Ga_{0.3}As$ | 8 |
| | i-$In_{0.53}Ga_{0.47}As$ | 5 |
| Buffer | i-$In_{0.52}Al_{0.48}As$ | 100 |
| Substrate | S.I.-InP | $6 \times 10^5$ |

Table 2

| Layer | Material | Thickness (nm) |
|---|---|---|
| Cap | n-$In_{0.53}Ga_{0.47}As$ | 15 |
| | n-$In_{0.52}Al_{0.48}As$ | 15 |
| Etch-stop | n-InP | 6 |

(continued)

| Layer | Material | Thickness (nm) |
|---|---|---|
| Barrier | i-$In_{0.52}Al_{0.48}As$ | 15 |
| Channel | i-$In_{0.53}Ga_{0.47}As$ | 3 |
| | i-$In_{0.7}Ga_{0.3}As$ | 8 |
| | i-$In_{0.53}Ga_{0.47}As$ | 5 |
| Spacer | i-$In_{0.52}Al_{0.48}As$ | 3 |
| Carrier-supply | n-$In_{0.52}Al_{0.48}As$ | 5 |
| Buffer | i-$In_{0.52}Al_{0.48}As$ | 100 |
| Substrate | S.I.-InP | $6 \times 10^5$ |

In a normal heteroepitaxial layer structure (in which a carrier-doped layer for doping an electron carrier into an electron transport channel layer and a spacer layer are located between a gate electrode metal and the electron transport channel layer) type element (normal-type), the spacer layer and the carrier-supply layer are disposed on the channel layer as illustrated in Table 1. In an inverted heteroepitaxial layer structure (in which the carrier-doped layer for doping the electron carrier into the electron transport channel layer and the spacer layer are located below the electron transport channel layer) type element (inversed type), the spacer layer and the carrier-supply layer are disposed below the channel layer as illustrated in Table 2. A theory to be described later can be applied to both the normal type and the inversed type, and can be applied regardless of an irradiation direction of an infrared optical wave (a front surface irradiation method of applying the infrared optical wave from a front surface of an element, a back surface irradiation method of applying the infrared optical wave from the back surface of a substrate of the element, an in-plane irradiation method of applying the infrared optical wave from within a plane of the element using a waveguide or the like, and the like), and therefore, an idea according to the present embodiment can be applied to any heteroepitaxial layer structure and any infrared optical irradiation method.

In addition, the frequency down-conversion device 1 may have a structure of the field effect transistor in which a monoatomic layer material of carbon atoms (graphene) is used as the electron transport channel layer. In this case, in the layer structure of FIG. 3, the cap layers 11a and 11f may be read as metal underlying layers, the barrier layer 11b may be read as a gate insulating film layer, the channel and channel peripheral layer 11c may be read as a graphene channel layer, and the buffer layer 11d may be read as an underlying insulating film layer. In this structure, the graphene serving as the electron transport channel layer and the metal serving as the gate electrode face each other via an extremely thin gate insulating film layer, and a diode-type nonlinear current-voltage characteristic can be provided. For example, as disclosed in a literature "Andreas Hemmetter, Xinxin Yang, Zheng Wang, Martin Otto, Burkay Uzlu, Marcel Andree, Ullrich Pfeiffer, Andrei Vorobiev, Jan Stake, Max C. Lemme, Daniel Neumaier, "Terahertz Rectennas on flexible substrates based on one-dimensional metal-insulator-graphene diodes", ACS Applied Electronic Materials, vo. 3, pp. 3747-3752, 2021", this structure functions as an element that rectifies and converts a high-frequency (microwave/millimeter wave) electromagnetic wave into a DC signal by using the above-described diode-type nonlinear current-voltage characteristic, and is known as a rectenna (Rectenna: Rectifying Antenna (antenna element having a rectifying action)). The same nonlinear rectification effect as in the case of the above-described HEMT element can be obtained when this structure is applied. As an example, constituent materials of each layer are illustrated in Table 3. When materials are selected such that work functions of the gate electrode metal and an underlying metal (5.4 eV and 4.25 eV in a configuration example of Table 3, respectively) are smaller than a work function of a source/drain electrode metal (5.6 eV in a configuration example of Table 3), a diode forward bias characteristic is obtained when a positive bias is applied to the gate electrode, and the same nonlinear rectification effect as that of the above-described HEMT element is obtained.

Table 3

| Layer | Material | Thickness (nm) |
|---|---|---|
| Gate electrode metal layer | Pt | 80 |
| Underlying metal layer | Ti | 15 |
| Gate insulating film layer | $Al_2O_3$ (alumina) | 8 |
| Electron transport channel layer | Graphene | 0.6 |
| Underlying insulating film layer | h-BN (hexagonal boron nitride) | 100 |

(continued)

| Layer | Material | Thickness (nm) |
|---|---|---|
| Substrate | SiC | $4 \times 10^5$ |
| Source/drain electrode metal layer | Au | 120 |

(Modeling of Nonlinear Response)

When a terahertz wave having a polarization component parallel to a direction (channel length direction) connecting the source electrode 12 and the drain electrode 13 is applied to the frequency down-conversion device 1, a two-dimensional plasmon is excited in the channel layer. Then, an electron conduction current (photocurrent) is generated in the channel layer via the plasmonic hydrodynamic nonlinearity and the subsequent diode current nonlinearity generated between the second gate electrode 15 (G2) and the channel layer. When the optical data signal S1 and the optical subcarrier signal S2 are applied, a current component (photomixed signal S3) having the difference frequency $\Delta f_{opt}$ is generated by the photomixing.

In addition, when the LO signal S4 is input to the second gate electrode 15, the input signal is affected by the plasmonic hydrodynamic nonlinearity via the diode current nonlinearity, and current components of a fundamental wave and a high-order harmonic are excited in the channel layer. Then, the current components and the photomixed signal S3 are mixed (RF mixing), and the signal component (IF/BB signal S5) having the frequency f5 amplified via the diode current nonlinearity is output from the first gate electrode 14. The nonlinear response in such a frequency down-conversion device 1 is modeled, and the effect of improving the conversion gain by the gate readout method is considered.

(Plasmonic Hydrodynamic Nonlinearity)

First, the plasmonic hydrodynamic nonlinearity will be considered. An input voltage signal generated by inputting an optical signal or an LO signal is represented by V, and an output signal generated by the plasmonic hydrodynamic nonlinearity is represented by a nonlinear response function F(V). In this case, an output signal for the input voltage signal V ($V = \delta V \cdot \cos(\omega t)$) having a minute amplitude $\delta V$ and a minute angular frequency $\omega$ is expressed by the following Formula (1) when third-order and higher-order nonlinear terms are omitted. F''(0) and F'(0) in the formula are a first-order differential value and a second-order differential value of a function F at V = 0, respectively.

$$F(\delta V \cos \omega t) \approx F'(0)\delta V \cos \omega t + \frac{F''(0)}{2}(\delta V)^2 (\cos \omega t)^2$$

$$= F''(0)\left(\frac{\delta V}{2}\right)^2 + F'(0)\delta V \cos \omega t + F''(0)\left(\frac{\delta V}{2}\right)^2 \cos 2\omega t \qquad (1)$$

A first term on a right side of Formula (1) is a DC square-law detection component for the input voltage signal V.

As described above, in the frequency down-conversion device 1, unlike the terahertz wave detector, the optical data signal S1 and the optical subcarrier signal S2 are input together to a transistor. Further, the LO signal S4 is input to the transistor. Therefore, it is necessary to consider influences of the plasmonic hydrodynamic nonlinearity on two types of input voltage signals $V_1$ ($V_1 = \delta V_1 \cdot \cos(\omega_1 t)$) and $V_2$ ($V_2 = \delta V_2 \cdot \cos(\omega_2 t)$) having different frequencies. The output signal for the input voltage signal $V = V_1 + V_2$ is expressed by the following Formula (2) when third-order and higher-order nonlinear terms are omitted.

$$F(\delta V_1 \cos \omega_1 t + \delta V_2 \cos \omega_2 t)$$

$$\approx F''(0)\left[\left(\frac{\delta V_1}{2}\right)^2 + \left(\frac{\delta V_2}{2}\right)^2\right] + F'(0)(\delta V_1 \cos \omega_1 t + \delta V_2 \cos \omega_2 t)$$

$$+ F''(0)\left[\left(\frac{\delta V_1}{2}\right)^2 \cos 2\omega_1 t + \left(\frac{\delta V_2}{2}\right)^2 \cos 2\omega_2 t\right]$$

$$+ 2F''(0)\left(\frac{\delta V_1}{2}\right)\left(\frac{\delta V_2}{2}\right)[\cos(\omega_1 + \omega_2)t + \cos(\omega_1 - \omega_2)t] \qquad (2)$$

In the frequency down-conversion device 1, a component oscillating at an oscillation frequency $\Delta \omega$ ($\Delta \omega = \omega_1 - \omega_2$))

in a fourth term on a right side is important instead of the DC square-law detection component in the first term on the right side of Formula (2).

For example, assuming that input voltage signals corresponding to the optical data signal S1 and the optical subcarrier signal S2 are $V_1$ and $V_2$, respectively, it can be seen from the above-described Formula (2) that a component oscillating at the oscillation frequency $\Delta\omega$ in the fourth term on the right side of Formula (2) is generated with respect to these signal inputs. The oscillation frequency $\Delta\omega$ corresponds to the difference frequency $\Delta f_{opt}$ between the frequency f1 of the optical data signal S1 and the frequency f2 of the optical subcarrier signal S2. That is, a component (photomixed signal S3) oscillating at the frequency $\Delta\omega$ corresponding to the frequency $\Delta f_{opt}$ is obtained by the plasmonic hydrodynamic nonlinearity.

Next, assuming that an input voltage signal corresponding to the photomixed signal S3 is $V_1$ and an input voltage signal corresponding to the LO signal S4 is $V_2$, it can be seen from the above-described Formula (2) that a component oscillating at the oscillation frequency $\Delta\omega$ in the fourth term on the right side of Formula (2) is generated with respect to these signal inputs. The oscillation frequency $\Delta\omega$ corresponds to the difference frequency f5 between the frequency $\Delta f_{opt}$ of the photomixed signal S3 and the frequency f4 of the LO signal S4. That is, the above-described Formula (2) indicates that a component (IF/BB signal S5) oscillating at a frequency corresponding to the absolute difference $|\Delta f_{opt} - f4|$ is obtained by the plasmonic hydrodynamic nonlinearity.

(Diode Current Nonlinearity and Three-Dimensional Rectification Effect)

However, in a case where the LO signal S4 is output from the second gate electrode 15 (gate LO input), when the LO signal S4 is input to the transistor, the LO signal S4 is affected by the diode current nonlinearity to be described later. The diode current nonlinearity is a nonlinear characteristic in which a current exponentially increases with an increase in forward voltage, and an output signal for an input signal $V_{in}$ is proportional to $G(V_{in}) = \exp(\alpha V_{in}) - 1$. In consideration of this influence, the input voltage signal V corresponding to the input of the photomixed signal S3 and the LO signal S4 is expressed by the following Formula (3). When the LO signal S4 is output from the drain electrode 13 (drain LO input), the above-described Formula (2) is established.

$$V = \delta V_1 \cos \omega_1 t + \beta G(\delta V_2 \cos \omega_2 t) \approx \delta V_1 \cos \omega_1 t + \alpha\beta \delta V_2 \cos \omega_2 t + \alpha^2 \beta \left(\frac{\delta V_2}{2}\right)^2 \qquad (3)$$

A product $\alpha\beta$ in the formula represents a ratio of an input voltage corresponding to the LO signal S4 at the gate LO input to an input voltage corresponding to the LO signal S4 at the drain LO input. The product $\alpha\beta$ is a parameter determined by an input impedance of a drain/gate. Assuming that a loss due to impedance mismatch is sufficiently small and is ignored, and $\alpha\beta = 1$, the nonlinear response function F(V) for the input voltage signal V of Formula (3) is expressed by Formula (4).

$$F\big(\delta V_1 \cos \omega_1 t + \beta G(\delta V_2 \cos \omega_2 t)\big)$$

$$\approx \left\{ F''(0)\left[\left(\frac{\delta V_1}{2}\right)^2 + \left(\frac{\delta V_2}{2}\right)^2\right] + \alpha F'(0)\left(\frac{\delta V_2}{2}\right)^2 \right\} + F'(0)(\delta V_1 \cos \omega_1 t + \delta V_2 \cos \omega_2 t)$$

$$+ F''(0)\left[\left(\frac{\delta V_1}{2}\right)^2 \cos 2\omega_1 t + \left(\frac{\delta V_2}{2}\right)^2 \cos 2\omega_2 t\right]$$

$$+ 2F''(0)\left(\frac{\delta V_1}{2}\right)\left(\frac{\delta V_2}{2}\right)[\cos(\omega_1 + \omega_2)t + \cos(\omega_1 - \omega_2)t] \qquad (4)$$

When Formula (4) is compared with Formula (2), it can be seen that a rectification component obtained by a gate terminal input is added to a first term on a right side of Formula (4). The drain LO input and the gate LO input differ depending on whether this rectification component is present, and the difference affects the conversion gain as described later.

In the frequency down-conversion device 1, since the IF/BB signal S5 is output from the first gate electrode 14, the diode current nonlinearity further acts on the output signal expressed by the above-described Formula (4). That is, an output signal output from the first gate electrode 14 is G (F(V)). When the above-described Formula (4) is substituted into a nonlinear response function G based on the diode current nonlinearity and a component $G_{\omega 1-\omega 2}$ of the oscillation frequency $\Delta\omega$ ($\Delta\omega = \omega_1 - \omega_2$) is extracted, the following Formula (5) is obtained.

$$G_{\omega_1 - \omega_2} \approx \exp\left\{\alpha F''(0)\left[\left(\frac{\delta V_1}{2}\right)^2 + \left(\frac{\delta V_2}{2}\right)^2\right] + \alpha^2 F'(0)\left(\frac{\delta V_2}{2}\right)^2\right\}$$

$$\times 2\{\alpha F''(0) + [\alpha F'(0)]^2\}\left(\frac{\delta V_1}{2}\right)\left(\frac{\delta V_2}{2}\right)\cos(\omega_1 - \omega_2)t \quad (5)$$

Incidentally, in a case of an existing method (drain readout method) of reading the IF/BB signal from the drain electrode, the output signal read from the drain electrode is represented by the following Formula (6). When Formula (5) and Formula (6) are compared, it can be seen that Formula (6) has no exponential factor. That is, in the gate readout method, the output signal is enhanced by the exponential factor, and the conversion gain is improved. An effect of enhancing the output signal by a synergistic effect of the plasmonic hydrodynamic nonlinearity and the diode current nonlinearity may be referred to as a "three-dimensional rectification effect".

$$G_{\omega_1 - \omega_2}\big|_{\text{Drain} - \text{Out}} \approx 2\{\alpha F''(0) + [\alpha F'(0)]^2\}\left(\frac{\delta V_1}{2}\right)\left(\frac{\delta V_2}{2}\right)\cos(\omega_1 - \omega_2)t \quad (6)$$

(Quantitative Evaluation of Exponential Factor)

According to a reference document "M. Dyakonov and M. Shur, "Detection, mixing, and frequency multiplication of terahertz radiation by two-dimensional electronic fluid", IEEE Trans. Electron Devices, vol.43, no.3, pp.380-387 (1996)", a second-order differential of F, F", is expressed by the following Formula (7).

$$F''(0) = \frac{\epsilon \epsilon_0}{e N_0 W_g} f(\omega\tau, s\tau/L_g) \quad (7)$$

Here, $e = 1.6 \times 10^{-19}$ [C] (absolute value of elementary charge), $N_0$ is an electron density in a two-dimensional electron channel, $W_g$ is a channel-gate spacing, $\epsilon$ is a relative dielectric constant of a material around the two-dimensional electron channel, $\epsilon_0 = 8.85 \times 10^{-12}$ [F/m] (dielectric constant of vacuum), and f ($\omega\tau$, $s\tau/L_g$)) is a factor representing an intensity of plasmon resonance. $\omega$ is a frequency of the input signal, $\tau$ is an electron momentum relaxation time in the two-dimensional electron channel, $L_g$ is a gate length, and s is a phase velocity of plasmon represented by the following Formula (8). In Formula (8), m* is an electron effective mass in the two-dimensional electron channel.

$$s = \sqrt{\frac{e^2 N_0 W_g}{m^* \epsilon \epsilon_0}} \quad (8)$$

When $\epsilon = 12$, $W_g = 20$ [nm], $N_0 = 10^{16}$ [m$^2$], m* $= 3.92 \times 10^{-32}$ [kg] and $\tau = 0.27$ [ps] are used as general values in InP-HEMT, s $= 1.11 \times 10^6$ [m/s] and $s\tau/L_g = 1.5$. Assuming that the frequency $\omega$ of the input signal is 1 THz, $\omega\tau = 1.7$. From these numerical values and the above-described reference document (see FIG. 3(a)), the factor f ($\omega\tau$, $s\tau/L_g$) representing the intensity of plasmon resonance is about 5. When these numerical values are substituted into the above-described Formula (7), F"(0) = 16.6 [V$^{-1}$].

A factor $\alpha$ included in the function G representing the diode current nonlinearity is represented by the following Formula (9).

$$\alpha = \frac{e}{\eta k_B T} \quad (9)$$

Here, $k_B = 1.38 \times 10^{-23}$ [J/K] (Boltzmann constant), T is a temperature (room temperature: T = 300 [K]), and $\eta$ is an ideal coefficient of a diode current-voltage characteristic (here, it is assumed that $\eta = 1$). When these numerical values are substituted into Formula (9), $\alpha = 38$ [V$^{-1}$].

Assuming that an arrayed resonant tunneling diode, which is a typical terahertz transmission element, is used to generate the LO signal S4, when an output power at 1 THz is 0.7 mW and a coupling efficiency at the time of electrode input is 20%, a signal intensity input to the second gate electrode 15 is 0.14 mW, and an input voltage amplitude of the LO signal S4 ($\delta V_2$) is 0.118 [V]). When the above-described numerical values of $\alpha$, F"(0), and $\delta V_2$ are substituted into the exponential factors of the above-described Formula (5), the following Formula (10) is obtained.

$$\exp[\{\alpha F''(0) + \alpha^2 F'(0)\}\delta V_2^2/4] \approx 236 \quad (10)$$

From the above-described results, it is clear that the conversion gain can be improved by about two orders of magnitude in the configuration of the frequency down-conversion device 1 (the gate readout method and the gate LO input) compared to a configuration of an existing drain readout method. This effect is different in principle from an improvement in the detection sensitivity implemented by a gate readout type terahertz wave detector, and it is difficult to predict such an improvement effect in the conversion gain without the theoretical consideration as described above. That is, it is clear that a person skilled in the art cannot easily conceive the configuration of the frequency down-conversion device 1 according to the present embodiment based on knowledge of the existing gate readout type terahertz wave detector.

(Embodiment 1: Asymmetric Diffraction Grating Gate Structure)

Next, the asymmetric diffraction grating gate structure will be described with reference to FIGS. 2 and 3. In the examples of FIGS. 2 and 3, the plurality of first fingers 14a, ..., 14d and the plurality of second fingers 15a, ..., 15d are arranged in the nested manner. Here, a first finger and a second finger adjacent to each other are referred to as a "finger pair". In the examples of FIGS. 2 and 3, the electrode structure is obtained in which a distance d3 between adjacent finger pairs is constant, and the finger pairs are periodically arranged.

When a distance between the first finger and the second finger in each finger pair is denoted as a first distance d1, and a distance between the second finger of a certain finger pair and the first finger of a finger pair adjacent thereto is denoted as a second distance d2, in the examples of FIGS. 2 and 3, d1 ≠ d2, resulting in an asymmetric electrode structure. When the asymmetric electrode structure is used as described above, the photocurrent generated in the channel layer is controlled in one direction (direction from the source electrode 12 to the drain electrode 13) by a difference between an impedance Z1 at the portion d1 and an impedance Z2 at the portion d2. Therefore, the output signal can be obtained without applying a bias voltage to the drain electrode 13.

(Embodiment 2: Improvement of Response Time Characteristic)

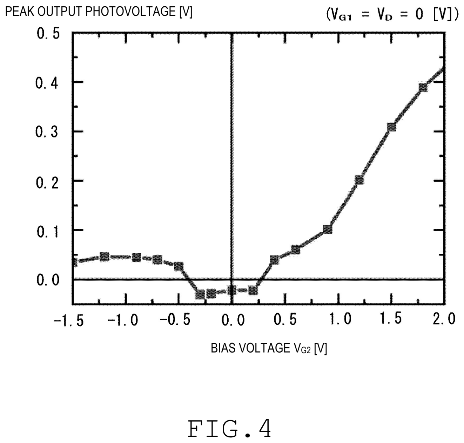

Next, with reference to FIGS. 4 to 8, the response time characteristic of the frequency down-conversion device 1 will be considered. The present inventor prototyped a device having the same configuration as that of the normal-type frequency down-conversion device 1, and examined an optical response characteristic by irradiating the device with a single terahertz light pulse while changing a bias voltage $V_{G2}$ to be applied to the second gate electrode 15. First, it was confirmed that there is a relation as illustrated in FIG. 4 between a peak output photovoltage from the first gate electrode 14 and the bias voltage $V_{G2}$. Here, the bias voltage $V_{G2}$ at a point where the peak photovoltage is 0 in a region where the bias voltage $V_{G2}$ is positive is referred to as a "first threshold voltage TH1", and the bias voltage $V_{G2}$ at a point where the peak photovoltage is 0 in a region where the bias voltage $V_{G2}$ is negative is referred to as a "second threshold voltage TH2".

In a region where the bias voltage $V_{G2}$ is greater than the first threshold voltage TH1 (hereinafter, referred to as a first bias voltage region), the peak output photovoltage greatly increases as the bias voltage $V_{G2}$ increases. On the other hand, in a region where the bias voltage $V_{G2}$ is less than the second threshold voltage TH2 (hereinafter, referred to as a second bias voltage region), the peak output photovoltage slightly increases as the bias voltage $V_{G2}$ decreases, and then a certain level of peak output photovoltage is obtained. From this, it is considered that sufficient data signal output is obtained in both the first bias voltage region and the second bias voltage region in the gate readout method.

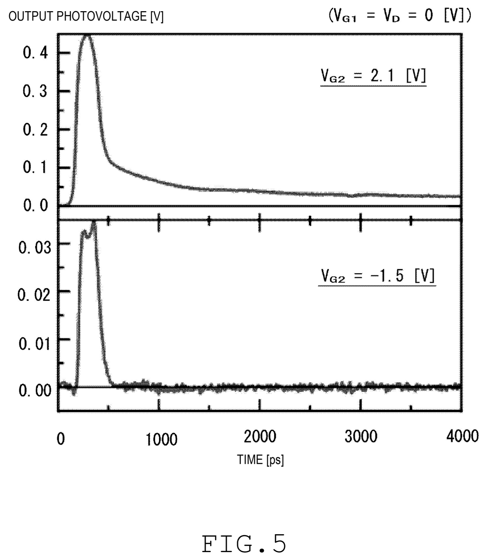

In addition, the present inventor obtained results illustrated in FIG. 5 regarding respective time-varying characteristics of an output photovoltage in the first bias voltage region and the second bias voltage region. An upper graph illustrates temporal variation of the output photovoltage in the first bias voltage region ($V_{G2}$ = 2.1 [V]), and a lower graph illustrates temporal variation of the output photovoltage in the second bias voltage region ($V_{G2}$ = -1.5 [V]).

When both graphs are compared, in the upper graph, the output photovoltage does not converge to 0 even after 3000 [ps] and continues to gradually decrease while maintaining a certain value or more, whereas in the lower graph, the output photovoltage converges to nearly 0 at around 600 [ps]. Therefore, in the normal-type frequency down-conversion device 1, it is preferable to apply a negative bias voltage $V_{G2}$ less than the second threshold voltage TH2 to the second gate electrode 15 from the viewpoint of improving the response time characteristic.

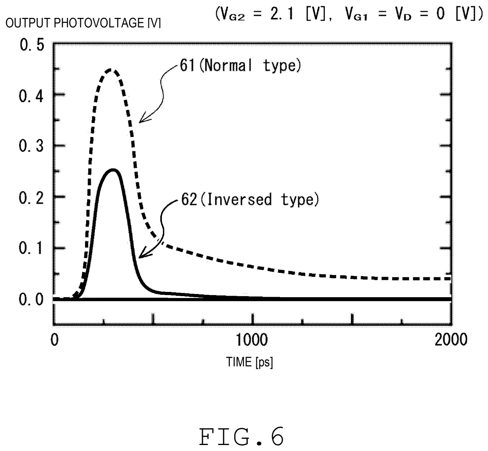

Further, the present inventor obtained a comparison result between the normal type (graph 61 in FIG. 6) and the inversed type (graph 62 in FIG. 6) with respect to the temporal variation of the output photovoltage in the case of the first bias voltage region ($V_{G2}$ = 2.1 [V]). From this comparison result, it was found that in the first bias voltage region, unlike the normal type, the output photovoltage converges to approximately 0 in a short time in the inversed type. Therefore, from the viewpoint of improving the response time characteristic, the inversed type is preferable to the normal type, and in the inversed-type frequency down-conversion device 1, it is preferable to apply a positive bias voltage $V_{G2}$ greater than the first threshold voltage TH1 to the second gate electrode 15.

(Variation 1: Two-Dimensional Diffraction Grating Gate Structure)

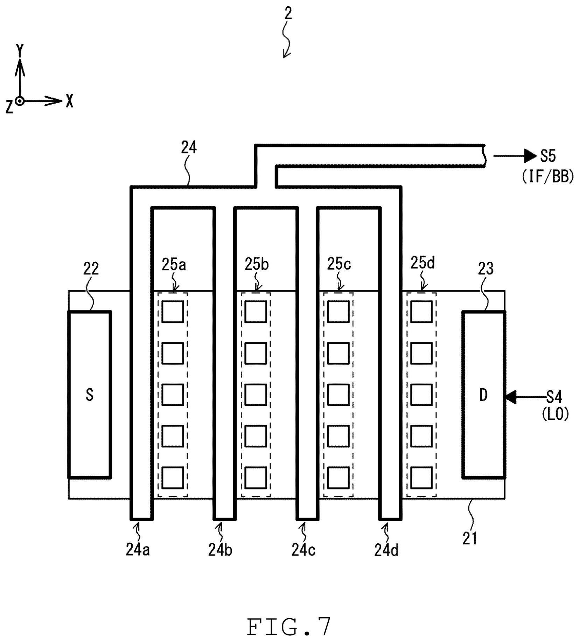

Up to this point, the electrode configuration in which two comb-shaped gate electrodes are arranged in the nested manner has been described as an example, but the electrode configuration to which the idea of the present embodiment can be applied is not limited to this example. For example, an electrode configuration (two-dimensional diffraction grating gate structure) as illustrated in FIG. 7 is also included in the application range. A frequency down-conversion device 2 illustrated in FIG. 7 is an example of a frequency down-conversion device according to a variation of the present embodiment.

In the example of FIG. 7, the frequency down-conversion device 2 includes a source electrode 22, a drain electrode 23, a gate electrode 24, and a plurality of electrode blocks 25a, ..., 25d. The electrodes are arranged on a mesa 21. The gate electrode 24 includes a plurality of second fingers 24a, ..., 24d arranged in parallel at regular intervals. Each of the plurality of electrode blocks 25a, ..., 25d includes a plurality of floating patch electrodes. Two adjacent floating patch electrodes of each electrode block are arranged at a constant interval. In addition, the plurality of floating patch electrodes of the electrode block are arranged at a certain interval from the finger, which is adjacent to the electrode block, of the gate electrode 24.

The source electrode 22 is grounded, and the LO signal S4 is input to the drain electrode 23. A constant bias voltage may be applied to the drain electrode 23. The LO signal S4 has the frequency f4 close to a difference frequency Δf between the frequency f1 of the optical data signal S1 and the frequency f2 of the optical subcarrier signal S2. The frequency down-conversion device 2 outputs, from the gate electrode 24, the IF/BB signal S5 having the frequency f5 corresponding to an absolute difference |Δf - f4| between the frequency f4 and the difference frequency Δf. The gate electrode 24 corresponds to the above-described first gate electrode 14. The mesa 21 has the same layer structure as the above-described mesa 11.

Similarly to the above-described frequency down-conversion device 1, when a terahertz wave having a polarization component (first polarization component) parallel to the channel length direction is applied to the frequency down-conversion device 2, the two-dimensional plasmon is excited in the mesa 21, and the photocurrent is generated in the channel layer. Further, since the plurality of floating patch electrodes also function as diffraction gate electrodes for a polarization component (second polarization component) perpendicular to the channel length direction, the two-dimensional plasmon can be excited by the second polarization component of the terahertz wave. Therefore, in the frequency down-conversion device 2, responses to both the first and second polarization components are obtained. In this way, by providing the floating patch electrodes, each polarization component of an incident optical wave can be converted into a photocurrent.

As described above, similarly to the above-described frequency down-conversion device 1, the gate readout method is adopted in the frequency down-conversion device 2. On the other hand, the LO signal S4 is not input to the gate electrode (second gate electrode 15) but is instead input to the drain electrode 23. That is, the frequency down-conversion device 2 adopts the drain LO input. That is, the above-described Formula (2) is established for a mixing process of the photomixed signal S3 and the LO signal S4. Therefore, when only the oscillation frequency $\Delta\omega$ ($\Delta\omega = \omega_1 - \omega_2$) is extracted, the output signal G (F(V)) in consideration of the diode current nonlinearity is expressed by the following Formula (11).

$$G_{\omega_1-\omega_2} \approx \exp\left\{\alpha F''(0)\left[\left(\frac{\delta V_1}{2}\right)^2 + \left(\frac{\delta V_2}{2}\right)^2\right]\right\}$$

$$\times 2\{\alpha F''(0) + [\alpha F'(0)]^2\}\left(\frac{\delta V_1}{2}\right)\left(\frac{\delta V_2}{2}\right)\cos(\omega_1 - \omega_2)t \quad (11)$$

Similarly to the above-described Formula (5), exponential factors appear on a right side of Formula (11). Similarly to the above-described Formula (10), the following Formula (12) is obtained by calculating specific values of the exponential factors.

$$\exp[\alpha F''(0)\delta V_2^2/4] = 8.96 \quad (12)$$

From the above-described results, it is clear that the conversion gain can be improved by about one order of magnitude in the configuration of the frequency down-conversion device 2 (the gate readout method and the drain LO input) compared to the configuration of the existing drain readout method. This effect is different in principle from the improvement in the detection sensitivity implemented by the gate readout type terahertz wave detector, and it is difficult to predict such an improvement effect in the conversion gain without the theoretical consideration as described above. That is, it is clear that a person skilled in the art cannot easily conceive the configuration of the frequency down-conversion device 2 according to the variation of the present embodiment based on the knowledge of the existing gate readout type terahertz wave detector.

By the way, compared to the frequency down-conversion device 1 of the gate LO input, the frequency down-conversion device 2 of the drain LO input has a conversion gain that is about one order of magnitude smaller, but if the LO signal S4 having a relatively large amplitude can be input, it is possible to implement a conversion gain that is sufficiently practical. Since it is relatively easy to control the amplitude of the LO signal S4, the configuration of the frequency down-conversion device 2 is also useful.

(Variation 2: Three-Electrode Configuration)

In the frequency down-conversion device 2 according to the above-described variation, the floating patch electrodes are provided to obtain responses to the polarization components in the channel length direction and the direction perpendicular thereto. However, the above-described theory holds true even in a configuration in which the floating patch electrodes are omitted from the frequency down-conversion device 2, that is, the three-electrode configuration (a configuration including only the source electrode 22, the drain electrode 23, and the gate electrode 24). In other words, even the configuration is modified to the three-electrode configuration, the enhancement by the exponential factors illustrated in the above-described Formula (12) is obtained by the three-dimensional rectification effect, so that the effect of improving the conversion gain can be obtained. Naturally, such variations also fall within a technical scope of the present embodiment.

(Communication Device)

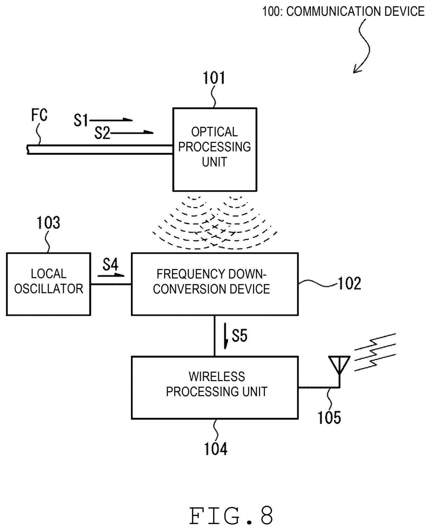

Here, with reference to FIG. 8, a communication device 100 in which the above-described frequency down-conversion devices 1 and 2 can be integrated will be described. As illustrated in FIG. 8, the communication device 100 includes an optical processing unit 101, a frequency down-conversion device 102, a local oscillator 103, and a wireless processing unit 104. The frequency down-conversion device 102 is a gate readout type frequency down-conversion device, and is, for example, the above-described frequency down-conversion devices 1 and 2.

The optical processing unit 101 receives the optical data signal S1 and the optical subcarrier signal S2 transmitted via the optical fiber FC, and inputs the optical data signal S1 and the optical subcarrier signal S2 to the frequency down-conversion device 102. The LO signal S4 is input to the frequency down-conversion device 102 from the local oscillator 103. For example, in the above-described configuration of the frequency down-conversion device 1, the LO signal S4 is input to the second gate electrode 15. On the other hand, in the above-described configuration of the frequency down-conversion device 2, the LO signal S4 is input to the drain electrode 23.

In the frequency down-conversion device 102, the photomixed signal S3 is generated by the photomixing of the optical data signal S1 and the optical subcarrier signal S2, and the IF/BB signal S5 is generated by the RF mixing of the photomixed signal S3 and the LO signal S4. The IF/BB signal S5 is read out from a gate electrode (the first gate electrode 14, the gate electrode 24, or the like) of the frequency down-conversion device 102 and input to the wireless processing unit 104. The wireless processing unit 104 generates a wireless signal from the IF/BB signal S5 and transmits the wireless signal via an antenna 105.

The communication device 100 may further include a control device (not illustrated) for controlling operations of the optical processing unit 101, the frequency down-conversion device 102, the local oscillator 103, and the wireless processing unit 104. The control device includes, for example, a processor and a memory. The processor may be a central processing unit (CPU), a digital signal processor (DSP), an application specific integrated circuit (ASIC), or a field programmable gate array (FPGA). The memory may be a storage medium such as a read only memory (ROM), a random access memory (RAM), a hard disk drive (HDD), a solid state drive (SSD), or a flash memory.

Although the preferred embodiment of the present invention has been described above with reference to the accompanying drawings, the present invention is not limited to such examples. It is apparent to a person skilled in the art that various modifications or variations can be conceived within the scope of the claims, and the modifications or variations naturally belong to the technical scope of the invention.

Reference Signs List

1, 2, 102: frequency down-conversion device
11, 21: mesa
11a, 11f: cap layer
11b: barrier layer
11c: channel and channel peripheral layer

11d: buffer layer
11e: substrate
12, 22: source electrode
13, 23: drain electrode
14: first gate electrode
15: second gate electrode
14a, ..., 14d, 15a, ..., 15d: finger
24: gate electrode
25a, ..., 25d: electrode set (floating patch electrode)
100: communication device
101: optical processing unit
103: local oscillator
104: wireless processing unit
105: antenna
FC: optical fiber cable
S1: optical data signal
S2: optical subcarrier signal
S3: photomixed signal
S4: local oscillation signal (LO signal)
S5: intermediate frequency signal/baseband signal (IF/BB signal)

## Claims

1. A frequency down-conversion device receiving input of an optical data signal and an optical subcarrier signal having different frequencies in an infrared optical frequency band, and outputting a data signal having a frequency in a radio wave band or a baseband, wherein

   the device has a structure of a field effect transistor in which a source electrode, a drain electrode, a first gate electrode having a plurality of first fingers arranged in parallel at regular intervals, and a second gate electrode having a plurality of second fingers arranged in parallel at regular intervals are arranged on a mesa, the plurality of first fingers and the plurality of second fingers being arranged in a nested manner, and
   a local oscillation signal having a predetermined frequency that is close to a difference frequency between a frequency of the optical data signal and a frequency of the optical subcarrier signal and that is in a band from sub-terahertz to terahertz, is input to the second gate electrode, and the device is configured to output, from the first gate electrode, the data signal having a frequency corresponding to an absolute difference between the predetermined frequency and the difference frequency.

2. The frequency down-conversion device according to claim 1, wherein
   a first distance between one first finger and one second finger among two second fingers adjacent to the one first finger is different from a second distance between the one first finger and the other second finger.

3. The frequency down-conversion device according to claim 1, wherein

   the device has a structure of a normal-layer type of a field effect transistor in which a remote-doped layer for supplying an electron carrier to an electron transport channel layer, and a spacer layer are located between a gate metal electrode and the electron transport channel layer, and
   a bias voltage less than a negative second threshold is applied to the second gate electrode.

4. The frequency down-conversion device according to claim 1, wherein

   the device has a structure of an inversed-layer type of a field effect transistor in which a remote-doped layer for supplying an electron carrier to an electron transport channel layer, and a spacer layer are located below the electron transport channel layer, and
   a bias voltage greater than a positive first threshold is applied to the second gate electrode.

5. The frequency down-conversion device according to claim 1, wherein

the device has a structure of a field effect transistor including a source/drain electrode metal layer, a gate electrode metal layer, an underlying metal layer disposed below the gate electrode, a gate insulating film layer, an electron transport channel layer, an underlying insulating film layer, and a substrate, the source electrode and the drain electrode form the source/drain electrode metal layer, the first gate electrode and the second gate electrode form the gate electrode metal layer, the electron transport channel layer is made of graphene, the source/drain electrode metal layer is made of a metal species having a work function greater than that of the gate electrode metal layer and the underlying metal layer, and

a bias voltage greater than a positive first threshold is applied to the second gate electrode.

6. A communication device, comprising:

an optical processing unit configured to input the optical data signal and the optical subcarrier signal transmitted via an optical fiber to the frequency down-conversion device according to claim 1;
the frequency down-conversion device; and
a wireless processing unit configured to convert the data signal output from the frequency down-conversion device into a wireless signal and transmit the wireless signal via an antenna.

7. A frequency down-conversion device receiving input of an optical data signal and an optical subcarrier signal having different frequencies in an infrared optical frequency band, and outputting a data signal having a frequency in a radio wave band or a baseband, wherein

the device has a structure of a field effect transistor in which a source electrode, a drain electrode, and a gate electrode having a plurality of fingers arranged in parallel at regular intervals are arranged on a mesa, and
a local oscillation signal having a predetermined frequency that is close to a difference frequency between a frequency of the optical data signal and a frequency of the optical subcarrier signal and that is in a band from sub-terahertz to terahertz, is input to the drain electrode, and the device is configured to output, from the gate electrode, the data signal having a frequency corresponding to an absolute difference between the predetermined frequency and the difference frequency.

8. The frequency down-conversion device according to claim 7, further comprising:
a plurality of floating patch electrodes that is arranged on the mesa and that is arranged at a certain distance from each finger.

S1

OPTICAL
DATA
SIGNAL (f1)

1

FREQUENCY DOWN-CONVERSION DEVICE

1b

1a

S5

IF/BB
SIGNAL (f5)

OPTICAL
SUBCARRIER
SIGNAL (f2)

PHOTOMIXING

PHOTO-
MIXED
SIGNAL

RF MIXING

S2

S3

LO SIGNAL
(f4)

S4

FIG.1

FIG.2

FIG.3

FIG.4

FIG.5

FIG.6

FIG.7

100: COMMUNICATION DEVICE

101

FC
S1
S2

OPTICAL
PROCESSING
UNIT

103

LOCAL
OSCILLATOR

S4

FREQUENCY DOWN-
CONVERSION DEVICE

102

S5

WIRELESS
PROCESSING UNIT

105

104

FIG.8

**EP 4 723 176 A1**

## INTERNATIONAL SEARCH REPORT

| International application No. |
|---|
| **PCT/JP2023/020345** |

**A. CLASSIFICATION OF SUBJECT MATTER**

*H01L 31/10*(2006.01)i; *G02F 2/02*(2006.01)i
FI: H01L31/10 E; G02F2/02

According to International Patent Classification (IPC) or to both national classification and IPC

**B. FIELDS SEARCHED**

Minimum documentation searched (classification system followed by classification symbols)

H01L31/10; G02F2/02

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2006/030608 A1 (KYUSHU INSTITUTE OF TECHNOLOGY) 23 March 2006 (2006-03-23)<br>entire text, all drawings | 1-8 |
| A | JP 2015-175957 A (NIPPON TELEGRAPH AND TELEPHONE CORPORATION) 05 October 2015 (2015-10-05)<br>entire text, all drawings | 1-8 |
| A | JP 2001-186092 A (NIPPON TELEGRAPH AND TELEPHONE CORPORATION) 06 July 2001 (2001-07-06)<br>entire text, all drawings | 1-8 |
| A | JP 06-196933 A (ATR OPTICAL AND RADIO COMMUNICATIONS RESEARCH LABORATORIES) 15 July 1994 (1994-07-15)<br>entire text, all drawings | 1-8 |
| A | JP 2001-188140 A (NIPPON TELEGRAPH AND TELEPHONE CORPORATION) 10 July 2001 (2001-07-10)<br>entire text, all drawings | 1-8 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **07 July 2023** | **18 July 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/020345**

| Patent document cited in search report | | | Publication date (day/month/year) | Patent family member(s) | | | Publication date (day/month/year) |
|---|---|---|---|---|---|---|---|
| WO | 2006/030608 | A1 | 23 March 2006 | US | 2008/0315216 | A1 | |
| | | | | EP | 1804347 | A1 | |
| JP | 2015-175957 | A | 05 October 2015 | (Family: none) | | | |
| JP | 2001-186092 | A | 06 July 2001 | (Family: none) | | | |
| JP | 06-196933 | A | 15 July 1994 | (Family: none) | | | |
| JP | 2001-188140 | A | 10 July 2001 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5747420 B
- US 7915641 B

**Non-patent literature cited in the description**

- **A.SATOU et al.** Unitraveling-Carrier-Photodiode-Integrated High-Electron-Mobility Transistor for Photonic Double-Mixing. *Journal of Lightwave Technology*, 2021, vol. 39 (10), 3341-3349
- **A.SATOU et al.** UTC-PD-integrated HEMT for optical-to-terahertz carrier frequency down-conversion. *Proceedings of SPIE*, 2020, vol. 11390
- **A.SATOU** ; **T.OTSUJI**. Recent progress in the development of grating-gate InGaAs-channel HEMTs for fast and sensitive THz detection. *Proceedings of SPIE*, 2022, vol. 12230
- **ANDREAS HEMMETTER** ; **XINXIN YANG** ; **ZHENG WANG** ; **MARTIN OTTO** ; **BURKAY UZLU** ; **MARCEL ANDREE** ; **ULLRICH PFEIFFER** ; **ANDREI VOROBIEV** ; **JAN STAKE** ; **MAX C. LEMME**. Terahertz Rectennas on flexible substrates based on one-dimensional metal-insulator-graphene diodes. *ACS Applied Electronic Materials*, 2021, vol. 3, 3747-3752
- **M. DYAKONOV** ; **M. SHUR**. Detection, mixing, and frequency multiplication of terahertz radiation by two-dimensional electronic fluid. *IEEE Trans. Electron Devices*, 1996, vol. 43 (3), 380-387